# EUROPEAN PATENT APPLICATION

(11) **EP 1 551 003 A2**
(43) Date of publication of application: **06.07.2005**
(21) Application number: 04258066.2
(22) Date of filing: 22.12.2004
(51) Int. Cl.: G09G 3/36, G09G 3/32

(54) **Display device**

(30) Priority: 25.12.2003 JP 2003430284
(71) Applicant: Sanyo Electric Co., Ltd., Moriguchi-shi, Osaka 570-8677 (JP)
(72) Inventor: Senda, Michiru, Gifu-shi Gifu 502-0911 (JP)
(74) Representative: Calderbank, Thomas Roger

(57) **Abstract**

The present invention provides a display capable of suppressing increase of consumed electric current. The display includes a first conductive type first transistor (PT1, NT1) whose source or drain is connected to a signal line (HENB1, HENB2, VENB) provided with a signal switched between a first voltage and a second voltage, the first transistor being ON in response to a clock signal provided, and the source or drain of the first transistor being provided with a signal of the first voltage from the signal line during at least a period where the first transistor is ON in response to the clock signal, a first conductive type second transistor (PT2, NT2) connected to the first voltage supply source side, and a first conductive type third transistor (PT3, NT3) connected between the gate of the first transistor and the first voltage supply source to bring the first transistor to OFF state when the second transistor is in ON state.

## Description

The present invention relates to a display, and more particularly to a display including a shift register circuit.

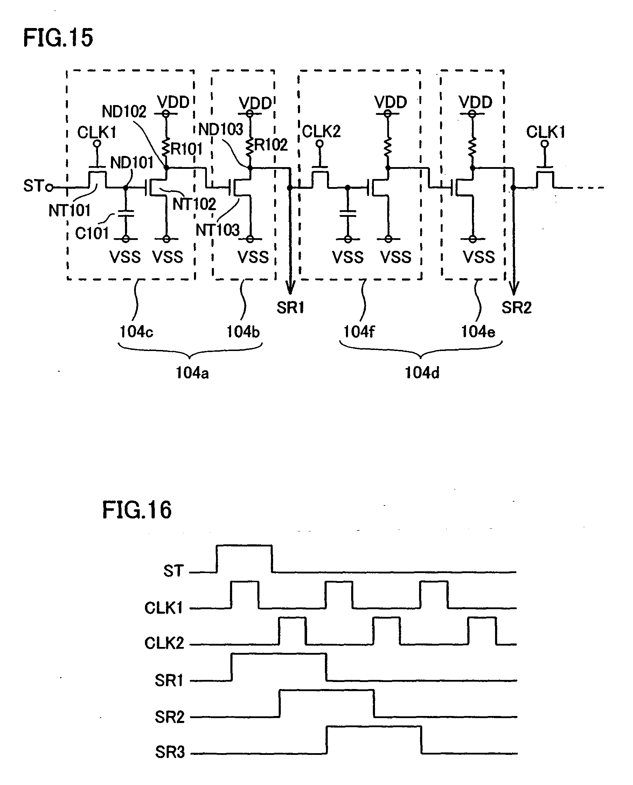

A resistance load type inverter circuit with load resistance is known in general. This type of inverter circuit is disclosed in "HANDOTAI DEVICE NO KISO" (KISHINO, Seigo, Ohmsha, Ltd., 25th April 1985, pp184-187), for example. In addition, a shift register circuit having the resistance load type inverter circuit disclosed in the above "HANDOTAI DEVICE NO KISO" (KISHINO, Seigo, Ohmsha, Ltd., 25th April 1985, pp184-187) is known in general. A shift register circuit is used for a circuit, which drives gate lines or drain lines of a liquid crystal display or organic electroluminescence display. Fig. 15 is a circuit diagram of a shift register circuit, which has conventional resistance load type inverter circuits. With reference to Fig. 15, a conventional shift register circuit 104a of first stage is constituted of an output-side circuit portion 104b and an input-side circuit portion 104c. A shift register circuit 104d of the stage subsequent to the shift register circuit 104a is constituted of an output-side circuit portion 104e and an input-side circuit portion 104f.

The input-side circuit portion 104c of the shift register circuit 104a of first stage has n-channel transistors NT101 and NT102, a capacitor C101, and a resistor R101. Hereafter, in this description of background art, the n-channel transistors NT101, NT102, and NT103 are referred to as transistors NT101, NT102, and NT103, respectively. A start signal ST is provided to the drain of the transistor NT101. The source is connected to a node ND101. The gate of the transistor NT101 is connected to a clock signal line CLK1. The source of the transistor NT102 is connected to a lower voltage supply source VSS. The drain is connected to the node ND102. One electrode of the capacitor C101 is connected to the lower voltage supply source VSS. The other electrode is connected to the node ND101. The resistor R101 is connected between the node ND102 and a higher voltage supply source VDD. The inverter circuit is constituted of the transistor NT102 and the resistor R101.

The output-side circuit portion 104b of the shift register circuit 104a of first stage is constituted of the inverter circuit, which is composed of the transistor NT103 and a resistor R102. The source of the transistor NT103 is connected to the lower voltage supply source VSS. The drain is connected to the node ND103. The gate of the transistor NT103 is connected to the node ND102 in the input-side circuit portion 104c. The resistor R102 is connected between the node ND103 and the higher voltage supply source VDD. An output signal SR1 of the shift register circuit 104a of first stage is provided from the node ND103. The node ND103 is connected to the input-side circuit portion 104f of the shift register circuit 104d of second stage.

Shift register circuits of second stage and later have constitution similar to the aforementioned shift register circuit 104a of first stage. The input-side circuit portion of a shift register circuit of a later stage is connected to the output node of the shift register circuit of the previous stage.

Fig. 16 is a timing chart of the conventional shift register circuit shown in Fig. 15. The operation of the conventional shift register circuit is described with reference to Figs. 15 and 16.

First, the start signal ST of L level is provided, in an initial state. Then, after the start signal ST is set to H level, the clock signal CLK1 is set to H level. Thus, the clock signal CLK1 of H level is provided to the gate of the transistor NT101 of the input-side circuit portion 104c in the shift register circuit 104a of first stage, and the transistor NT101 turns to ON state. Thus, the start signal ST of H level is provided to the gate of the transistor NT102, and the transistor NT102 turns to ON state. Accordingly, since the voltage of the node ND102 drops to L level, the transistor NT103 turns to OFF state. Thus, since the voltage of the node ND103 goes up, the output signal SR1 of H level is provided from the shift register circuit 104a of first stage. This output signal SR1 of H level is also provided to the input-side circuit portion 104f of the shift register circuit 104d of second stage. In addition, the capacitor C101 accumulates the voltage of H level during a period where the clock signal CLK1 is H level.

Subsequently, the clock signal CLK1 is set to L level. Thus, the transistor NT101 turns to OFF state. After that, the start signal ST is set to L level. In this case, even if the transistor NT101 turns to OFF state, since the voltage of the node ND101 is held at H level by the voltage of H level accumulated in the capacitor C101, the transistor NT102 is held in ON state. Thus, since the voltage of the node ND102 is held at L level, the voltage of the gate of the transistor NT103 is held at L level. Accordingly, since the transistor NT103 is held in OFF state, the output signal SR 1 of H level is continuously provided from the output-side circuit portion 104b of the shift register circuit 104a of first stage.

Next, the clock signal CLK2 provided to the input-side circuit portion 104f the shift register circuit 104d of second stage is set to H level. In the shift register circuit 104d of second stage, the clock signal CLK2 of H level is provided in the state where the output signal SR1 of H level from the shift register circuit 104a of first stage is provided. Thus, the shift register circuit 104d of second stage operates similarly to the aforementioned shift register circuit 104a of first stage. Accordingly, an output signal SR2 of H level is provided from the output-side circuit portion 104e of the shift register circuit 104d of second stage.

After that, the clock signal CLK1 is set to H level again. Thus, the transistor NT101 of the input-side circuit portion 104c in the shift register circuit 104a of first stage turns to ON state. In this case, the start signal ST is set to L level, thereby, the voltage of the node ND101 drops to L level. Accordingly, since the transistor NT102 turns to OFF state, the voltage of the node ND102 goes up to H level. Thus, the transistor NT103 turns to ON state, and the voltage of the node ND103 drops from H level to L level. Accordingly, the output signal SR1 of L level is provided from the output-side circuit portion 104b of the shift register circuit 104a of first stage. According to the aforementioned operation, output signals (SR1, SR2, SR3, ...) of H level shifted in timing are sequentially provided from the respective shift register circuits of stages.

However, in the conventional shift register circuit shown in Fig. 15, since the transistor NT102 in the shift register circuit 104a of first stage is held in ON state during the period where the output signal SR1 is H level, there is a disadvantage that a flow-through current flows between the higher voltage supply source VDD and the lower voltage supply source VSS through the resistor R101 and the transistor NT102. In addition, since the transistor NT103 is held in ON state during the period where the output signal SR1 is L level, there is a disadvantage that a flow-through current flows between the higher voltage supply source VDD and the lower voltage supply source VSS through the resistor R102 and the transistor NT103. Accordingly, there are disadvantages that a flow-through current always flows between the higher voltage supply source VDD and the lower voltage supply source VSS in the both cases of the output signal SR1 of H level and L level. Moreover, the shift register circuits of the other stages have constitution similar to the shift register circuit 104a of first stage. Accordingly, there are disadvantages that a flow-through current always flows between the higher voltage supply source VDD and the lower voltage supply source VSS in the both cases of each output signal of H level and L level, similarly to the shift register circuit 104a of first stage. As a result, in the case where the aforementioned conventional shift register circuit is used for a circuit which drives the gate or drain lines of the liquid crystal display or organic electroluminescence display, there is a problem that a consumed electric current of the liquid crystal display or organic electroluminescence display increases.

The present invention has been made to provide a display capable of suppressing increase of consumed electric current.

To solve the above problem, a display according to one aspect of the present invention comprises a shift register circuit including a first circuit portion in output-side, wherein the first circuit portion in output-side has a first conductive type first transistor whose source or drain is connected a signal line provided with a signal switched between a first voltage and a second voltage, the first transistor being ON in response to a clock signal provided from a clock signal line, and the source or drain of the first transistor being provided with a signal of the first voltage from the signal line during at least a period where the first transistor is ON in response to the clock signal, a first conductive type second transistor connected to the first voltage supply source side, and a first conductive type third transistor connected between the gate of the first transistor and the first voltage supply source to bring the first transistor to OFF state when the second transistor is in ON state.

Since the display according to this aspect suppresses that the first transistor, and the second transistor which is connected to the first voltage supply source side are in ON state at the same time, in the first circuit portion, even in the case where a signal of the second voltage is provided to the first transistor during a period where the first transistor is ON, it also suppresses that a flow-through current flows between the first voltage supply source side and the second voltage supply source side through the first transistor, to which the second voltage is provided, and the second transistor connected to the first voltage supply source side. Therefore, it is possible to suppress increase of consumed electric current in the display comprising the shift register circuit including the first circuit portion. In addition, since the first transistor serves as a capacitor during a period where it is ON, the gate voltage of the first transistor goes up or drops so as to hold the voltage between the gate and source of the first transistor as the source voltage of the first transistor goes up or drops. Therefore, even in the case where the source voltage of the first transistor goes up or drops, it is possible to hold the first transistor in ON state. Additionally, in the case a signal of the first voltage is provided from the signal line to one of the source and the drain of the first transistor during at least a period where the first transistor is ON in response to the clock signal, the voltage of the one of the source and the drain of the first transistor is held at the first voltage during a period where the first transistor is brought to ON by the clock signal, and the second voltage can be provided from the signal line to the one of the source and the drain of the first transistor after the first transistor is brought to OFF by the clock signal. Accordingly, when the second voltage is provided to the first transistor, since the first transistor can be stably held in ON state due to the function of the first transistor as a capacitor without influence of the clock signal, the output of the first circuit portion can be reliably brought to the second voltage through the first transistor. Furthermore, since the one of the source and the drain of the first transistor is brought to the first voltage by a signal of the first voltage during the period where the first transistor is brought to ON by the clock signal, a flow-through current does not flow through the first transistor and the second transistor which is connected to the first voltage supply source side. As a result, it is also possible to suppress increase of consumed electric current in the display. Moreover, the first transistor, the second transistor, and the third transistor are formed as first conductive type. Accordingly, it is possible to reduce the number of ion implantation processes and the number of the ion implantation masks as compared with the case where a shift register circuit including two conductive types of transistors is formed. Therefore, it is possible to simplify a manufacturing process and to reduce manufacturing cost.

In the drawings
Fig. 1 is a plan view showing a liquid crystal display according to a first embodiment of the present invention;
Fig. 2 is a circuit diagram of a shift register circuit which constitutes an H-driver of the liquid crystal display according to the first embodiment shown in Fig. 1;
Fig. 3 is a schematic view for illustrating the structure of a p-channel transistor having two gate electrodes;
Fig. 4 is a timing chart of the shift register circuit of the H-driver of the liquid crystal display according to the first embodiment shown in Fig. 2;
Fig. 5 is a circuit diagram of a shift register circuit which constitutes a V-driver of a liquid crystal display according to a second embodiment of the present invention;
Fig. 6 is a timing chart of the shift register circuit of the V-driver of the liquid crystal display according to the second embodiment shown in Fig. 5;
Fig. 7 is a plan view showing a liquid crystal display according to a third embodiment of the present invention;
Fig. 8 is a circuit diagram of a shift register circuit which constitutes an H-driver of the liquid crystal display according to the third embodiment shown in Fig. 7;
Fig. 9 is a schematic view for illustrating the structure of an n-channel transistor having two gate electrodes;
Fig. 10 is a timing chart of the shift register circuit of the H-driver of the liquid crystal display according to the third embodiment shown in Fig. 8;
Fig. 11 is a circuit diagram of a shift register circuit which constitutes a V-driver of a liquid crystal display according to a fourth embodiment of the present invention;
Fig. 12 is a timing chart of the shift register circuit of the V-driver of the liquid crystal display according to the fourth embodiment shown in Fig. 11;
Fig. 13 is a plan view showing an organic electroluminescence display according to a fifth embodiment of the present invention;
Fig. 14 is a plan view showing an organic electroluminescence display according to a sixth embodiment of the present invention;
Fig. 15 is a circuit diagram of a shift register circuit, which has conventional resistance load type inverter circuits; and
Fig. 16 is a timing chart of the conventional shift register circuit shown in Fig. 15.

Embodiments of the present invention are now described with reference to the drawings.

### FIRST EMBODIMENT

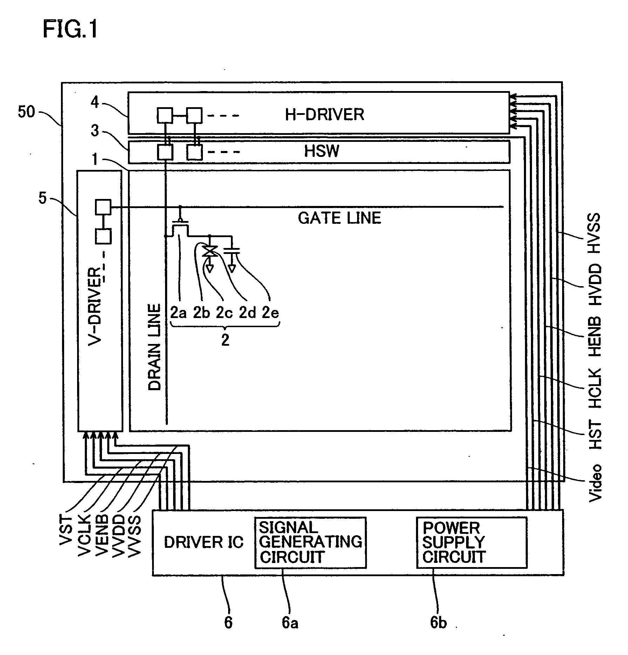

With reference to Fig. 1, in a first embodiment, a display portion 1 is provided on a circuit board 50. The constitution corresponding to one pixel is shown in the display portion 1 of Fig. 1. Pixels 2 are arranged in a matrix shape in the display portion 1. Each of pixels 2 is constituted of a p-channel transistor 2a, a pixel electrode 2b, a common electrode 2c common to the pixels 2 which is opposed to the pixel electrode 2b, a liquid crystal 2d which is interposed between the pixel electrode 2b and the common electrode 2c, and a subsidiary capacitance 2e. The source of the p-channel transistor 2a is connected to a drain line. The drain is connected to the pixel electrode 2b and the subsidiary capacitance 2c. The gate of the p-channel transistor 2a is connected to a gate line.

A horizontal switch (HSW) 3 and an H-driver 4 for driving (scanning) the drain lines of the display portion 1 are provided on the circuit board 50 along one side of the display portion 1. A V-driver 5 for driving (scanning) the gate lines of the display portion 1 is provided on the circuit board 50 along the other side of the display portion 1. A driver IC 6 is provided outside the circuit board 50. The driver IC 6 includes a signal generating circuit 6a and a power supply circuit 6b. A video signal Video, a start signal HST, a clock signal HCLK, an enable signal HENB, a higher voltage HVDD, and a lower voltage HVSS are provided from the driver IC 6 to the H-driver 4. A start signal VST, a clock signal VCLK, an enable signal VENB, a higher voltage VVDD, and a lower voltage VVSS are provided from the driver IC 6 to the V-driver 5. The higher voltages HVDD and VVDD are examples of a "first voltage" in the present invention. The lower voltages HVSS and VVSS are examples of a "second voltage" in the present invention.

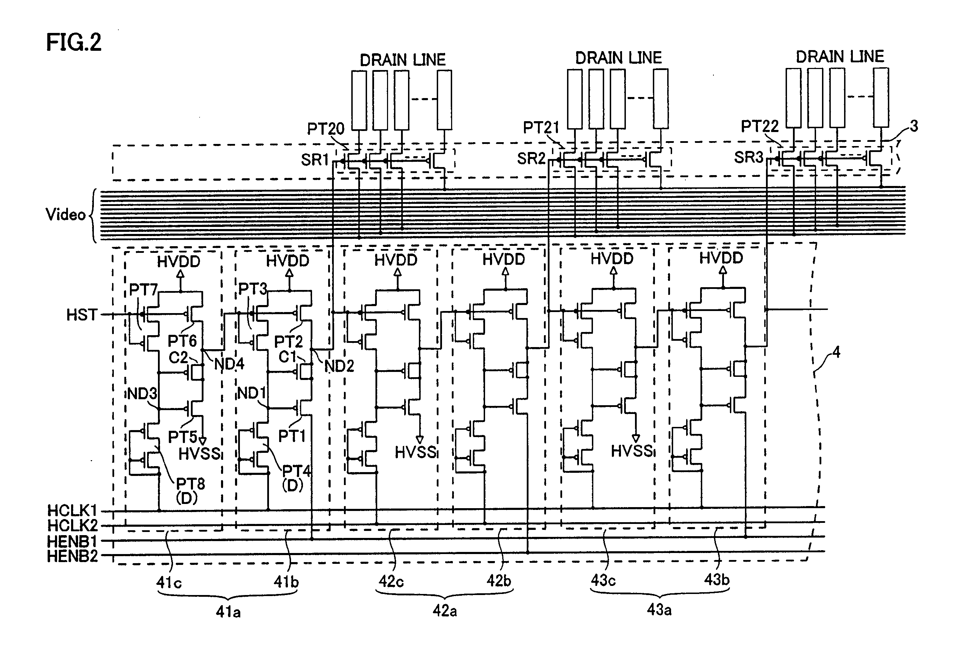

As shown in Fig. 2, a plurality of stages of shift register circuits 41a, 42a, and 43a are provided inside the H-driver 4. In Fig. 2, only three stages of shift register circuits 41a, 42a and 43a are shown for ease of illustration. The shift register circuit 41a of first stage is constituted of an output-side circuit portion 41b and an input-side circuit portion 41c. The output-side circuit portion 41b and the input-side circuit portion 41c are examples of a "first circuit portion" and a "second circuit portion" in the present invention, respectively. The output-side circuit portion 41b includes p-channel transistors PT1, PT2 and PT3, a diode-connected p-channel transistor PT4, and a capacitor C1 formed by connecting between the source and the drain of a p-channel transistor. The p-channel transistors PT1, PT2, PT3, and PT4 are examples of a "first transistor", a "second transistor", a "third transistor", and a "fourth transistor" in the present invention, respectively. The capacitor C1 is an example of a "first capacitor" in the present invention. The input-side circuit portion 41c includes p-channel transistors PT5, PT6 and PT7, a diode-connected p-channel transistor PT8, and a capacitor C2 formed by connecting between the source and the drain of a p-channel transistor. The p-channel transistors PT5, PT6, PT7, and PT8 are examples of a "fifth transistor", a "sixth transistor", a "seventh transistor", and an "eighth transistor" in the present invention, respectively. The capacitor C2 is an example of a "second capacitor" in the present invention.

In the first embodiment, all of the p-channel transistors PT1 to PT8 provided in the output-side and input-side circuit portions 41b and 41c, and the p-channel transistors, which constitute the respective capacitors C1 and C2, are constituted of TFTs (thin-film transistors) composed of p-type MOS transistors (electric field effect transistors). Hereafter, the p-channel transistors PT1 to PT8 are referred to as transistors PT1 to PT8, respectively.

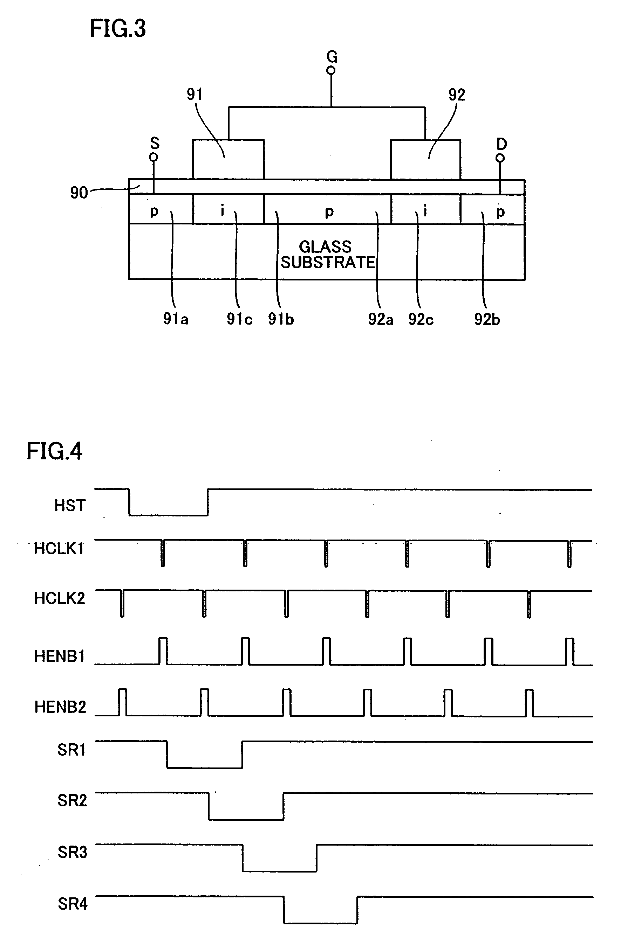

In the first embodiment, as shown in Fig. 3, the transistors PT3 and PT4 of the output-side circuit portion 41b and the transistors PT7 and PT8 of the input-side circuit portion 41c are formed so that each of them has two gate electrodes 91 and 92, which are electrically connected to each other. Specifically, a gate electrode 91 of one side and a gate electrode 92 of the other side are formed above a channel area 91c of the one side and a channel area 92c of the other side, respectively, so that a gate insulating film 90 is sandwiched between each gate electrode and each channel area. The channel area 91c of the one side is interposed between a p-type source area 91a of the one side and a p-type drain area 91b of the one side. The channel area 92c of the other side is interposed between a p-type source area 92a of the other side and a p-type drain area 92b of the other side. The p-type drain area 91b and the p-type source area 92a are constituted of a common p-type impurity area.

In the first embodiment, as shown in Fig. 2, in the output-side circuit portion 41b, the drain of the transistor PT1 is connected to an enable signal line (HENB1) . Accordingly, an enable signal HENB1 is provided to the drain of the transistor PT1. This enable signal line is an example of a "signal line" and a "first signal line" in the present invention. The source of the transistor PT1 is connected to a node ND2. The gate is connected to a node ND1. A clock signal HCLK1 is provided to the gate of the transistor PT1. The source of the transistor PT2 is connected to the higher voltage supply source HVDD. The drain is connected to the node ND2. An output signal of the input-side circuit portion 41c is provided to the gate of the transistor PT2.

In the first embodiment, the transistor PT3 is connected between the gate of the transistor PT1 and the higher voltage supply source HVDD. The output signal of the input-side circuit portion 41c is provided to the gate of the transistor PT3. The transistor PT3 is provided in order to bring the transistor PT1 to OFF state when the transistor PT2 is in ON state. This suppresses that the transistors PT2 and PT1 are in ON state at the same time.

In the first embodiment, the capacitor C1 is connected between the gate and the source of the transistor PT1. The transistor PT4 is connected between the gate of the transistor PT1 and a clock signal line (HCLK1). The transistor PT4 suppresses that the pulse voltage of the clock signal HCLK1 of H level flows backward from the clock signal line (HCLK1) to the capacitor C1. The clock signal line (HCLK1) is an example of a "clock signal line", and a "first clock signal line" in the present invention.

In the first embodiment, as shown in Fig. 2, in the input-side circuit portion 41c, the drain of the transistor PT5 is connected to the lower voltage supply source HVSS. The source of the transistor PT5 is connected to a node ND4. The gate is connected to a node ND3. The clock signal HCLK1 is provided to the gate of the transistor PT5. The source of the transistor PT6 is connected to the higher voltage supply source HVDD. The drain is connected to the node ND4. The start signal HST is provided to the gate of the transistor PT6.

In the first embodiment, the transistor PT7 is connected between the gate of the transistor PT5 and the higher voltage supply source HVDD. The start signal HST is provided to the gate of the transistor PT7. The transistor PT7 is provided in order to bring the transistor PT5 to OFF state when the transistor PT6 is in ON state. This suppresses that the transistors PT5 and PT6 are in ON state at the same time.

In the first embodiment, the capacitor C2 is connected between the gate and the source of the transistor PT5. The transistor PT8 is connected between the gate of the transistor PT5 and the clock signal line (HCLK1). The transistor PT8 suppresses that the pulse voltage of the clock signal HCLK1 of H level flows backward from the clock signal line (HCLK1) to the capacitor C2.

An output signal SR1 is provided from the node ND2 of the output-side circuit portion 41b (an output node of the shift register circuit 41a of first stage). The output signal SR 1 is provided to the horizontal switch 3.

The horizontal switch 3 includes a plurality of switching transistors PT20, PT21 and PT22. In Fig. 2, only the switching transistors PT20, PT21 and PT22 of first to third stages are shown for ease of illustration. Each of the switching transistors PT20 to PT22 includes a set of twelve p-channel transistors. The respective gates of each set of twelve p-channel transistors of the switching transistors PT20 to PT22 are connected to each of the outputs SR1, SR2, and SR3 of the shift register circuits 41a to 43a of first to third stages. The respective drains of each set of twelve p-channel transistors of the switching transistors PT20 to PT22 are connected to the drain lines of each stage. The respective sources of each set of twelve p-channel transistors of the switching transistors PT20 to PT22 are connected to separated video signal lines Video. More specifically, each of the respective switching transistors PT20 to PT22 of stages is connected to four sets (twelve lines) of video signal lines Video. Each one set of them is constituted of three video signal lines Video corresponding to red (R), green (G) and blue (B), respectively. Accordingly, since the set of twelve p-channel transistors connected to the four RGB sets (twelve lines) of video signal lines Video are driven by the output of the shift register circuit of one stage, the number of the shift register circuits is a quarter the number of the shift register circuits as compared with the constitution where three p-channel transistors connected to one RGB set (three lines) of video signal lines Video are driven by the output of a shift register circuit of one stage, for example. As a result, power consumption is reduced as compared with the constitution where three p-channel transistors connected to one RGB set (three lines) of video signal lines Video are driven by the output of a shift register circuit of one stage. The shift register circuit 42a of second stage is connected to the node ND2 (output node) of the shift register circuit 41a of first stage.

The shift register circuit 42a of second stage is constituted of an output-side circuit portion 42b and an input-side circuit portion 42c. The output-side and input-side circuit portions 42b and 42c of the shift register circuit 42a of second stage have circuit constitution similar to the aforementioned output-side and input-side circuit portions 41b and 41c of the shift register circuit 41a of first stage, respectively. The output signal SR2 is provided from the output node of the shift register circuit 42a of second stage. The shift register circuit 43a of third stage is connected to the output node of the shift register circuit 42a of second stage.

The shift register circuit 43a of third stage is constituted of an output-side circuit portion 43b and an input-side circuit portion 43c. The output-side and input-side circuit portions 43b and 43c of the shift register circuit 43a of third stage have circuit constitution similar to the aforementioned output-side and input-side circuit portions 41b and 41c of the shift register circuit 41a of first stage, respectively. The output signal SR3 is provided from the output node of the shift register circuit 43a of third stage. A shift register circuit of fourth stage (not shown) is connected to the output node of the shift register circuit 43a of third stage. Each of the respective output signals SR1 to SR3 of the aforementioned shift register circuits 41a to 43a is provided to the gates of each set of twelve p-channel transistors, which are connected to the video signal lines Video, of the switching transistors PT20 to PT22 of the horizontal switch 3.

Shift register circuits of fourth stage and later have circuit constitution similar to the aforementioned shift register circuits 41a to 43a of first to third stages. A clock signal line (HCLK2) and an enable signal line (HENB2) are connected to the aforementioned shift register circuit 42a of second stage. The clock signal line (HCLK2) is an example of the "clock signal line" and a "second clock signal line" in the present invention. The enable signal line (HENB2) is an example of the "signal line" and a "second signal line" in the present invention. The clock signal line (HCLK1) and the enable signal line (HENB1) are connected to the aforementioned shift register circuit 43a of third stage similarly to the shift register circuit 41a of first stage. As mentioned above, a set of the clock signal line (HCLK1) and the enable signal line (HENB1), and a set of the clock signal line (HCLK2) and the enable signal line (HENB2) are alternately connected to a plurality of stages of the shift register circuits. The shift register circuit of a later stage is connected to the output node of the shift register circuit of the previous stage.

The operation of the shift register circuits of the H-driver in the liquid crystal display according to the first embodiment is now described with reference to Figs. 2 and 4. In Fig. 4, SR1, SR2, SR3, and SR4 represent the output signals from the shift register circuits of first stage, second stage, third stage, and fourth stage, respectively.

First, the start signal HST of H level (HVDD) is provided to the input-side circuit portion 41c of the shift register circuit 41a of first stage, in an initial state. The transistors PT6 and PT7 of the input-side circuit portion 41c are in OFF state, and the transistor PT5 is in ON state. Thus, the voltage of the node ND4 is L level. Accordingly, in the output-side circuit portion 41b, the transistors PT2 and PT3 are in ON state. The voltage of the node ND1 is H level, thus, the transistor PT1 is in OFF state. In the output-side circuit portion 41b, the transistor PT2 is in ON state, and the transistor PT1 is in OFF state, thus, the voltage of the node ND2 is H level. Accordingly, in the initial state, the output signal SR1 of H level is provided from the shift register circuit 41a of first stage.

In the state where the output signal SR1 of H level is provided from the shift register circuit 41a of first stage, when the start signal HST of L level (HVSS) is provided, in the input-side circuit portion 41c, the transistors PT6 and PT7 turn to ON state. Both the voltages of the nodes ND3 and ND4 become H level, thus, the transistor PT5 turns to OFF state. Then, the voltage of the node ND4 becomes H level, in the output-side circuit portion 41b, thus, the transistors PT2 and PT3 turn to OFF state. In this case, the voltage of the node ND1 is held in the state of H level, thus, the transistor PT1 is held in OFF state. Accordingly, since the voltage of the node ND2 is held at H level, the output signal SR1 of H level is continuously provided from the shift register circuit 41a of first stage.

Subsequently, in the input-side circuit portion 41c, the clock signal HCLK1 of L level (HVSS) is provided through the transistor PT8. In this case, the transistor PT7 is in ON state, thus, the voltage of the node ND3 is held at H level. Accordingly, the transistor PT5 is held in OFF state. In addition, during a period where the clock signal HCLK1 is L level, a flow-through current flows between the clock signal line (HCLK1) and the higher voltage supply source HVDD through the transistors PT7 and PT8.

On the other hand, in the output-side circuit portion 41b, the enable signal HENB1 of H level is provided from the enable signal line (HENB1) to the source of the transistor PT1, thus, the source voltage of the transistor PT1 is held at H level. In this state, the clock signal HCLK1 of L level (HVSS) is provided through the transistor PT4. In this case, since the transistor PT3 is in OFF state, when the voltage of the node ND1 becomes L level, the transistor PT1 turns to ON state. Accordingly, the enable signal HENB1 of H level is provided from the enable signal line (HENB1) to the node ND2 (output node) through the transistor PT1 in ON state. Thus, the voltage of the node ND2 (output node) is held at H level. As a result, the output signal SR1 provided from the node ND2 (output node) of the shift register circuit 41a of first stage is forcedly held at H level during a prescribed period where the enable signal HENB1 of H level is provided from the enable signal line (HENB1) (a period corresponding to three clocks in the first embodiment).

Subsequently, when the clock signal HCLK1 provided from the clock signal line (HCLK1) to the transistor PT4 becomes H level, the transistor PT4 turns to OFF state, thus, the node ND1 turns to a floating state of L level. Then, when the enable signal HENB1 provided from the enable signal line (HENB1) to the source of the transistor PT1 turns to L level (HVSS), the source voltage of the transistor PT1 and the voltage of the node ND2 (output node) drop from H level (HVDD) to L level (HVSS) side. In this case, the voltage of the node ND1 (the gate voltage of the transistor PT1) drops so that the voltage between the gate and source of the transistor PT1 is maintained due to the function of capacitor C1 and MOS capacitor of transistor PT1 as the source voltage of the transistor PT1 (the voltage of the node ND2) drops. In addition, the transistor PT3 is in OFF state, and a signal of H level from the clock signal line (HCLK1) does not flow backward into the diode-connected transistor PT4 toward the node ND1 side. Thus, the maintained voltage of the capacitor C1 (the voltage between the gate and source of the transistor PT1) is maintained. Since the transistor PT1 is always maintained in ON state when the voltage of the node ND2 drops, the voltage of the node ND2 drops to HVSS. As a result, the output signal SR1 of L level is provided from the shift register circuit 41a of first stage.

In the output-side circuit portion 41b, when the voltage of the node ND2 drops to HVSS, the voltage of the node ND1 is lower than HVSS. Accordingly, a bias voltage applied to the transistor PT3, which is connected to the higher voltage supply source HVDD, becomes larger than the potential difference between HVDD and HVSS. In the case where the clock signal HCLK1 is set to H level (HVDD), the bias voltage applied to the transistor PT4, which is connected to the clock signal line (HCLK1), also becomes larger than the potential difference between HVDD and HVSS.

Subsequently, in the input-side circuit portion 41c, when the start signal HST of H level (HVDD) is provided, the transistors PT6 and PT7 turn to OFF state. In this case, the nodes ND3 and ND4 are in a floating state in the state where they are held at H level. For this reason, the other parts are not affected. Accordingly, the output signal SR 1 of L level is continuously provided from the shift register circuit 41a of first stage.

Subsequently, the enable signal HENB1 provided to the transistor PT1 of the output-side circuit portion 41b is set to H level (HVDD). Accordingly, the voltage of the node ND2 (output node) goes up to H level (HVDD) through the transistor PT1. As a result, the output signal SR1 of H level is provided from the shift register circuit 41a of first stage.

Subsequently, in the input-side circuit portion 41c, the clock signal HCLK1 of L level (HVSS) is provided through the transistor PT8 again. Accordingly, the transistor PT5 turns to ON state, thus, the voltage of the node ND4 drops from H level (HVDD) to L level (HVSS) side. In this case, the voltage of the node ND3 drops so that the voltage between the gate and source of the transistor PT5 is maintained due to the function of capacitor C2 and MOS capacitor of transistor PT5 as the source voltage of the transistor PT5 (the voltage of the node ND4) drops. At this time, the clock signal HCLK1 goes up from L level to H level. In this case, the transistor PT7 is in OFF state, and the clock signal HCLK1 of H level does not flow backward from the clock signal line (HCLK1) into the diode-connected transistor PT8 toward the node ND3 side. Thus, the maintained voltage of the capacitor C2 (the voltage between the gate and source of the transistor PT5) is maintained. Since the transistor PT5 is always maintained in ON state when the voltage of the node ND4 drops, the voltage of the node ND4 drops to HVSS. Accordingly, the transistors PT2 and PT3 of the output-side circuit portion 41b are in ON state. When the voltage of the node ND4 drops to HVSS, the voltage of the node ND3 is lower than HVSS.

In this case, in the output-side circuit portion 41b, when the transistor PT3 is turned to ON state, the transistor PT1 turns to OFF state. This suppresses that the transistors PT1 and PT2 turn to ON state at the same time. In the output-side circuit portion 41b, the transistor PT2 is in ON state, and the transistor PT1 is in OFF state, thus, the voltage of the node ND2 (output node) is maintained at H level (HVDD) . As a result, the output signal SR1 of H level is continuously provided from the shift register circuit 41a of first stage.

As mentioned above, in the shift register circuit 41a according to the first embodiment, in the case where the start signal HST of L level is provided to the input-side circuit portion 41c, after the enable signal HENB1 of H level and the clock signal HCLK1 of L level are provided to the output-side circuit portion 41b, when the enable signal HENB1 provided to the output-side circuit portion 41b is switched from H level (HVDD) to L level (HVSS), the output signal SR1 of L level (HVSS) is provided from the output-side circuit portion 41b.

The output signal SR1 from the output-side circuit portion 41b of the shift register circuit 41a of first stage is provided to the input-side circuit portion 42c of the shift register circuit 42a of second stage. In the shift register circuit 42a of second stage, in the case where the output signal SR1 of L level of the shift register circuit 41a of first stage is provided to the input-side circuit portion 42c, the enable signal HENB2 of H level and the clock signal HCLK2 of L level different from the clock signal HCLK1 in timing are provided to the output-side circuit portion 42b. After that, when the enable signal HENB2 provided to the output-side circuit portion 42b is switched from H level (HVDD) to L level (HVSS) , the output signal SR2 of L level is provided from the output-side circuit portion 42b. Thus, the shift register circuit of a later stage is provided with the output signal of L level from the shift register circuit of the previous stage, and a set of clock signal HCLK1 and enable signal HENB1, and a set of clock signal HCLK2 and enable signal HENB2, each set of which is shifted from each other in timing, are alternately provided to the respective shift register circuits of stages. As a result, the output signals of L level provided from the respective shift register circuits of stages are shifted in timing.

Then, each of the output signals of L level that are shifted in timing are provided to the respective gates of each set of twelve p-channel transistors of the switching transistors PT20 to PT22 of the horizontal switch 3, thus, the respective sets of twelve p-channel transistors of the switching transistors PT20 to PT22 sequentially turn to ON state every twelve p-channel transistors. Accordingly, the video signals are provided from the video signal lines Video to the drain lines of stages, thus, the drain lines of each stage are sequentially driven (scanned). When scanning of the drain lines of all the stages connected to one gate line is completed, the following gate line is selected. After the drain lines of the stages are sequentially scanned again, the following gate line is selected. This operation is repeated until scanning of the drain lines of the stages connected to the last gate line is completed, thus, scanning of one screen is completed.

In the first embodiment, as mentioned above, the output-side circuit portion 41b is provided with the transistor PT3 for bring the transistor PT1, which is connected to the enable signal line for providing the enable signal HENB1 that is switched between H level (HVDD) and L level (HVSS), to OFF state when the transistor PT2 connected to the higher voltage supply source HVDD is in ON state. Accordingly, it is possible to suppress that the transistor PT1 and the transistor PT2, which is connected to the higher voltage supply source HVDD, are in ON state at the same time. As a result, in the output-side circuit portion 41b, even in the case where the enable signal HENB1 of L level (HVSS) is provided to the transistor PT1 during a period the transistor PT1 is ON, it is possible to suppress that a flow-through current flows between the enable signal line (HENB1) and the higher voltage supply source HVDD through the transistor PT1, to which HVSS is provided, and the transistor PT2, which is connected to the higher voltage supply source HVDD. In addition, the input-side circuit portion 41c is provided with the transistor PT7 for bringing the transistor PT5, which is connected to the lower voltage supply source HVSS, to OFF state when the transistor PT6 connected to the higher voltage supply source HVDD is in ON state. Accordingly, it is possible to suppress that the transistor PT5 connected to the lower voltage supply source HVSS and the transistor PT6 connected to the higher voltage supply source HVDD are in ON state at the same time. As a result, it is possible to suppress that, in the input-side circuit portion 41c, a flow-through current flows between the lower voltage supply source HVSS and the higher voltage supply source HVDD through the transistor PT5 and the transistor PT6. As mentioned above, it is possible to suppress that a flow-through current through the transistors PT1 and PT2 of the output-side circuit portion 41b and a flow-through current through the transistors PT5 and PT6 of the input-side circuit portion 41c flow. Therefore, it is possible to suppress increase of consumed electric current in the liquid crystal display.

In the first embodiment, the transistor PT7 of the input-side circuit portion 41c is turned OFF, when the transistor PT3 of the output-side circuit portion 41b is in ON state. Since the transistor PT3 and the transistor PT7 are not ON at the same time, a flow-through current through the transistors PT3 and PT4 of the output-side circuit portion 41b and a flow-through current through the transistors PT7 and PT8 of the input-side circuit portion 41c do not flow at the same time. As a result, it is also possible to suppress increase of consumed electric current in the liquid crystal display.

As mentioned above, in the first embodiment, the enable signal HENB1 of H level (HVDD) is provided from the enable signal line (HENB1) to the source of the transistor PT1 during a period where the transistor PT1 is ON in response to the clock signal HCLK1 of L level. Thus, the source voltage of the transistor PT1 can be held at HVDD during a period where the transistor PT1 is ON based on the clock signal HCLK1, and the voltage of HVSS (L level) can be provided from the enable signal line (HENB1) to the source of the transistor PT1 after the transistor PT4 is turned OFF by the clock signal HCLK1. Accordingly, when the voltage of HVSS is provided to the transistor PT1, since the transistor PT1 can be stably held in ON state due to the function of the capacitor C1 and the MOS capacitor of the transistor PT1 without influence of the clock signal HCLK1, the output (SR1) of the output-side circuit portion 41b can be reliably brought to the voltage of HVSS through the transistor PT1. Furthermore, since the source voltage of the transistor PT1 is brought to HVDD by the enable signal HENB1 of H level (HVDD) during the period where the transistor PT1 is brought to ON by the clock signal HCLK1, a flow-through current does not flow through the transistor PT1 and the transistor PT2, which is connected to the higher voltage supply source HVDD. As a result, it is also possible to suppress increase of consumed electric current in the display.

In the first embodiment, each of the transistors PT3, PT4, PT7, and PT8 has two gate electrodes 91 and 92 electrically connected to each other. Thus, the voltage applied to each of the transistors PT3, PT4, PT7, and PT8 is distributed between the voltage between the source and drain corresponding to one gate electrode 91, and the voltage between the source and drain corresponding to the other gate electrode 92 about half each (the distribution ratio of voltage varies depending on transistor size and so on). Accordingly, even in the case where the bias voltage applied to each of the transistors PT3, PT4, PT7, and PT8 becomes larger than the potential difference between HVSS and HVDD, voltages smaller than the potential difference between HVSS and HVDD are applied between the source and drain corresponding to the one gate electrode 91, and between the source and drain corresponding to the other gate electrode 92 of each of the transistors PT3, PT4, PT7, and PT8. This suppresses deterioration of characteristics of each of the transistors PT3, PT4, PT7 and PT8 due to application of bias voltage larger than the potential difference between HVSS and HVDD to each of the transistors PT3, PT4, PT7 and PT8. Therefore, it is possible to suppress deterioration of scanning property of the liquid crystal display including the H-driver 4 with the shift register circuits 41a to 43a.

In the first embodiment, all of the transistors PT1 to PT8 provided in the output-side circuit portion 41b and the input-side circuit portion 41c, and the transistors, which constitute the capacitors C1 and C2, are constituted of TFTs (thin-film transistors) composed of p-type MOS transistors (electric field effect transistors). Accordingly, it is possible to reduce the number of ion implantation processes and the number of the ion implantation masks as compared with the case where a shift register circuit including two conductive types of transistors is formed. Therefore, it is possible to simplify a manufacturing process and to reduce manufacturing cost. In addition, since it is not necessary for p-type electric field effect transistors to have an LDD (Lightly Doped Drain) structure dissimilarly to n-type electric field effect transistors, it is possible to further simplify a manufacturing process.

### SECOND EMBODIMENT

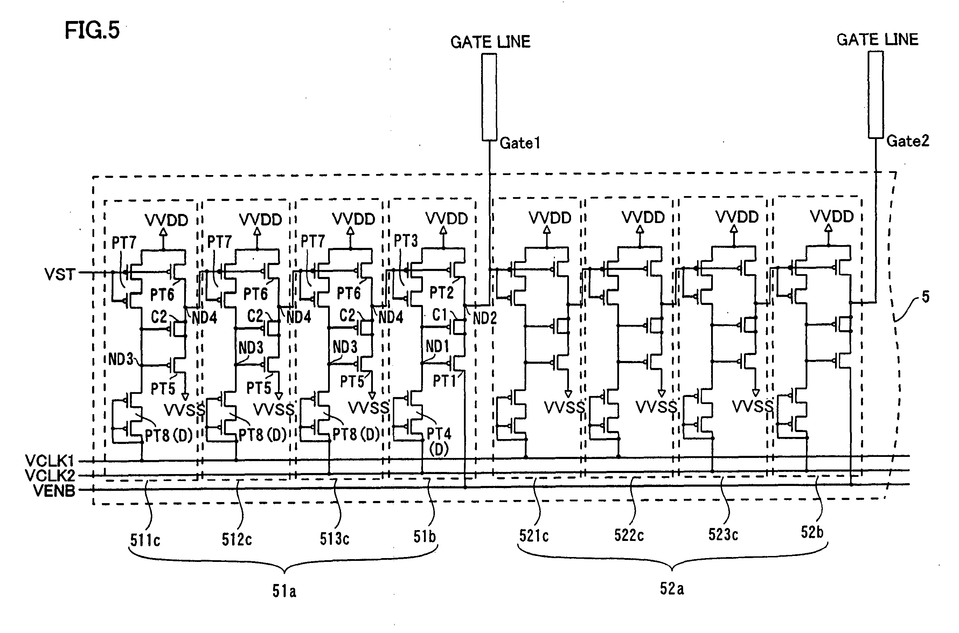

With reference to Fig. 5, in a second embodiment, dissimilarly to the foregoing first embodiment, the case where the present invention is applied to a V-driver for driving (scanning) gate lines is described.

In a V-driver 5 of a liquid crystal display according to the second embodiment, as shown in Fig. 5, a plurality stages of shift register circuits 51a and 52a are provided. In Fig. 5, only two stages of shift register circuits 51a and 52a are shown for ease of illustration. The shift register circuit 51a of first stage is constituted of an output-side circuit portion 51b, a first circuit portion 511c, a second circuit portion 512c, and a third circuit portion 513c. The output-side circuit portion 51b is an example of the "first circuit portion" in the present invention. The first to third circuit portions 511c to 513c are the examples of the "second circuit portion" in the present invention. The output-side circuit portion 51b includes transistors PT1, PT2 and PT3, a diode-connected transistor PT4, and a capacitor C1 formed by connecting between the source and the drain of a p-channel transistor. The first circuit portion 511c includes transistors PT5, PT6 and PT7, a diode-connected transistor PT8, and a capacitor C2 formed by connecting between the source and the drain of a p-channel transistor.

In the second embodiment, all of the transistors PT1 to PT8 provided in the output-side circuit portion 51b and the first circuit portion 511c, and the transistors, which constitute the capacitors C1 and C2, are constituted of TFTs (thin-film transistors) composed of p-type MOS transistors (electric field effect transistors).

In the second embodiment, the transistors PT3, PT4, PT7, and PT8 are formed so that each of them has two gate electrodes which are electrically connected to each other similarly to the first embodiment shown in Fig. 3.

In the second embodiment, as shown in Fig. 5, in the output-side circuit portion 51b, the drain of the transistor PT1 is connected to an enable signal line (VENB). Accordingly, an enable signal VENB is provided from the enable signal line (VENB) to the drain of the transistor PT1. The enable signal line (VENB) is an example of the "signal line" in the present invention. The source of the transistor PT1 is connected to a node ND2. The gate is connected to a node ND1. A clock signal VCLK2 is provided from a clock signal line (VCLK2) to the gate of the transistor PT1. The source of the transistor PT2 is connected to the higher voltage supply source VVDD. The drain is connected to the node ND2. The gate of the transistor PT2 is connected to a node ND4 of the third circuit portion 513c.

In the second embodiment, the transistor PT3 is connected between the gate of the transistor PT1 and the higher voltage supply source VVDD. The gate of the transistor PT3 is connected to the node ND4 of the third circuit portion 513c. The transistor PT3 is provided in order to bring the transistor PT1 to OFF state when the transistor PT2 is in ON state. This suppresses that the transistors PT2 and PT1 are in ON state at the same time.

In the second embodiment, the capacitor C1 is connected between the gate and the source of the transistor PT1. The transistor PT4 is connected between the gate of the transistor PT1 and the clock signal line (VCLK2). The transistor PT4 suppresses that the pulse voltage of the clock signal VCLK2 of H level flows backward from the clock signal line (VCLK2) to the capacitor C1.

In the first circuit portion 511c, the transistors PT5, PT6, PT7 and PT8 , and the capacitor C2 are essentially connected at the positions corresponding to the transistors PT1, PT2, PT3 and PT4, and the capacitor C1 of the output-side circuit portion 51b, respectively. However, in the first circuit portion 511c, both the source of the transistor PT5 and the drain of the transistor PT6 are connected to the node ND4, and the gate of the transistor PT5 is connected to the node ND3. The drain of the transistor PT5 is connected to the lower voltage supply source VVSS. The start signal VST is provided to the gate of the transistors PT6 and PT7.

The second and third circuit portions 512c and 513c have circuit constitution similar to the aforementioned first circuit portion 511c. The first, second and third circuit portions 511c, 512c and 513c are connected in series.

An output signal Gate1 of the shift register circuit 51a of first stage is provided from the node ND2 (output node) of the output-side circuit portion 51b. The gate line is connected to the node ND2. The node ND2 is connected to the shift register circuit 52a of second stage.

The shift register circuit 52a of second stage is constituted of an output-side circuit portion 52b, a first circuit portion 521c, a second circuit portion 522c, and a third circuit portion 523c. The output-side circuit portion 52b of the shift register circuit 52a of second stage has circuit constitution similar to the aforementioned output-side circuit portion 51b of the shift register circuit 51a of first stage. The first to third circuit portions 521c to 523c of the shift register circuit 52a of second stage have circuit constitution similar to the first to third circuit portions 511c to 513c of the aforementioned shift register circuit 51a of first stage. An output signal Gate2 is provided from the output node of the shift register circuit 52a of second stage. The gate line is connected to the output node of the shift register circuit 52a of second stage. A shift register circuit of third stage (not shown) is connected to the output node of the shift register circuit 52a of second stage. Shift register circuits of third stage and later have circuit constitution similar to the aforementioned shift register circuit 51a of first stage.

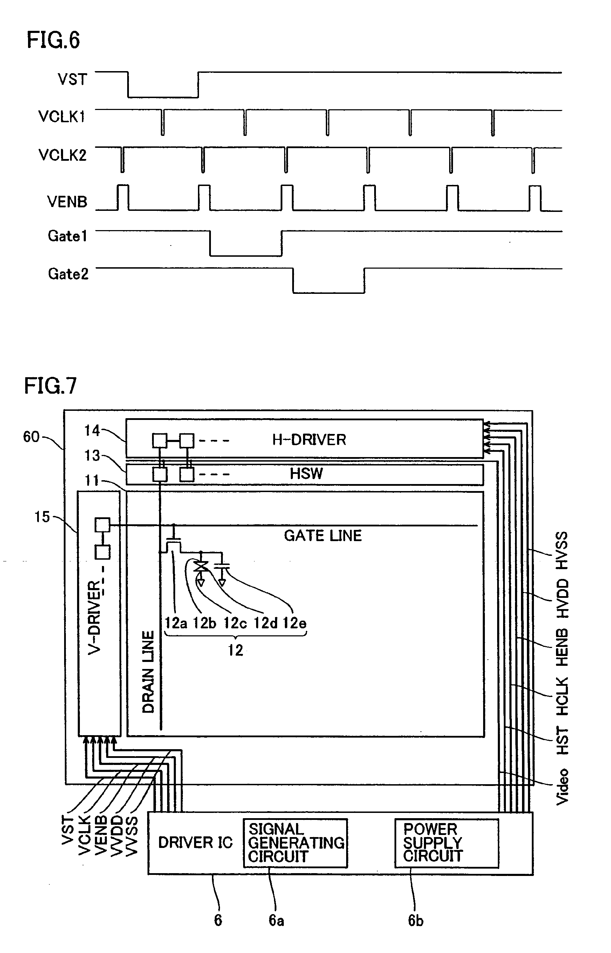

The operation of the shift register circuits of the V-driver in the liquid crystal display according to the second embodiment is now described with reference to Figs. 5 and 6. In Fig. 6, Gate1 and Gate2 represent the output signals provided from the shift register circuits of first and second stages to the gate lines, respectively.

The constitution of the first circuit portion 511c of the shift register circuit 51a of first stage according to the second embodiment shown in Fig. 5 corresponds to the constitution of the input-side circuit portion 41c of the shift register circuit 41a of first stage according to the first embodiment shown in Fig. 2. Accordingly, the operation of the first circuit portion 511c of the shift register circuit 51a of first stage according to the second embodiment performed in response to the start signal VST and the clock signal VCLK1 corresponds to the operation of the input-side circuit portion 41c of the shift register circuit 41a of first stage according to the first embodiment shown in Fig. 2 performed in response to the start signal HST and the clock signal HCLK1.

That is, first, the start signal VST of H level (VVDD) is provided to the first circuit portion 511c of the shift register circuit 51a of first stage in an initial state. Accordingly, a signal of L level is provided from the first circuit portion 511c by operation similar to the H-driver 4 of the aforementioned first embodiment. This signal of L level is provided to the gates of the transistors PT6 and PT7 of the second circuit portion 512c. The transistors PT6 and PT7 of the second circuit portion 512c turn to ON state, thus, a signal of H level is provided from the second circuit portion 512c. This signal of H level is provided to the transistors PT6 and PT7 of the third circuit portion 513c. The transistors PT6 and PT7 of the third circuit portion 513c turn to OFF state, thus, a signal of L level is provided from the third circuit portion 513c.

This signal of L level from the third circuit portion 513c is provided to the gates of the transistors PT2 and PT3 of the output-side circuit portion 51b. The transistors PT2 and PT3 of the output-side circuit portion 51b turn to ON state, thus, the voltage of the node ND2 becomes H level. Accordingly, in the initial state, the output signal Gate1 of H level is provided from the shift register circuit 51a of first stage to the gate line.

In this state, when the start signal VST of L level (VVSS) is provided, a signal of H level is provided from the first circuit portion 511c by operation similar to the H-driver 4 of the aforementioned first embodiment. This signal of H level is provided to the gates of the transistors PT6 and PT7 of the second circuit portion 512c, thus, the transistors PT6 and PT7 of the second circuit portion 512c turn to OFF state. The nodes ND3 and ND4 of the second circuit portion 512c turn to a floating state of H level, thus, a signal of H level is continuously provided from the second circuit portion 512c. A signal of L level is continuously provided from the third circuit portion 513c, thus, the output signal Gate1 of H level is continuously provided from the shift register circuit 51a of first stage to the gate line similarly to the initial state.

Subsequently, the clock signal VCLK1 of L level (VVSS) is provided from the clock signal line (VCLK1) through the transistor PT8 of the first circuit portion 511c. In this case, since the transistors PT6 and PT7 of the first circuit portion 511c are held in ON state, the voltage of the node ND3 of the first circuit portion 511c is held at H level. The transistor PT5 of the first circuit portion 511c is held in OFF state, thus, a signal of H level is continuously provided from the first circuit portion 511c. Then, the clock signal VCLK1 of L level (VVSS) is provided from the clock signal line (VCLK1) through the transistor PT8 of the second circuit portion 512c, thus, the transistor PT5 of the second circuit portion 512c turns to ON state. A signal of L level (VVSS) is provided from the second circuit portion 512c, thus, the transistors PT6 and PT7 of the third circuit portion 513c turn to ON state. A signal of H level (VVDD) is provided from the third circuit portion 513c, thus, the transistors PT2 and PT3 of the output-side circuit portion 51b turn to OFF state. In this case, since the clock signal VCLK2 of H level is provided from the clock signal line (VCLK2) to the transistor PT4 of the output-side circuit portion 51b, the transistor PT4 has turned to OFF state. The node ND1 is in a floating state of H level, thus, the transistor PT1 is held in OFF state. The node ND2 (output node) is in a floating state of H level, thus, the output signal Gate1 of H level is continuously provided from the shift register circuit 51a of first stage to the gate line.

Subsequently, the start signal VST of H level is provided to the transistors PT6 and PT7 of the first circuit portion 511c. The transistors PT6 and PT7 of the first circuit portion 511c turn to OFF state. The nodes ND3 and ND4 of the first circuit portion 511c turn to a floating state of H level, thus, a signal of H level is continuously provided from the first circuit portion 511c. Accordingly, a signal of L level is continuously provided from the second circuit portion 512c, and a signal of H level is continuously provided from the third circuit portion 513c. As a result, the output signal Gate1 of H level is continuously provided from the shift register circuit 51a of first stage to the gate line. The enable signal VENB of H level is provided from the enable signal line (VENB) to the source of the transistor PT1 of the output-side circuit portion 51b at the same timing as providing the start signal VST of H level to the transistors PT6 and PT7 of the first circuit portion 511c.

Subsequently, in this state, the clock signal VCLK2 of L level is provided from the clock signal line (VCLK2) to the transistor PT8 of the third circuit portion 513c. In this case, since the transistors PT6 and PT7 of the third circuit portion 513c have turned to ON state, the voltage of the node ND3 of the third circuit portion 513c is held at H level. The transistor PT5 of the third circuit portion 513c is held in OFF state, thus, a signal of H level is continuously provided from the third circuit portion 513c. Accordingly, the transistors PT2 and PT3 of the output-side circuit portion 51b are held in OFF state. On the other hand, the clock signal VCLK2 of L level is also provided from the clock signal line (VCLK2) to the transistor PT4 of the output-side circuit portion 51b. Accordingly, the transistor PT1 of the output-side circuit portion 51b turns to the ON state. In this case, since the enable signal VENB of H level is provided from the enable signal line (VENB) to the source of the transistor PT1, the output signal Gate1 provided from the shift register circuit 51a of first stage to the gate line is forcedly held at H level. After that, the clock signal VCLK2 provided to the transistor PT4 of the output-side circuit portion 51b turns from L level to H level. At this time, the node ND1 turns to a floating state of L level.

Subsequently, the enable signal VENB provided to the source of the transistor PT1 of the output-side circuit portion 51b drops from H level (VVDD) to the L level (VVSS) side. In this case, similarly to the foregoing first embodiment, due to the function of the capacitor C1 and the MOS capacitor of the transistor PT1 of the output-side circuit portion 51b, while the transistor PT1 is held in ON state, the voltage of the node ND2 (output node) drops from H level (VVDD) to L level (VVSS). As a result, the output signal Gate1 of L level is provided from the shift register circuit 51a of first stage to the gate line.

The output signal Gate1 of L level from the shift register circuit 51a of first stage is also provided to the first circuit portion 521c of the shift register circuit 52a of second stage. The shift register circuit of second stage or later performs operation similar to the aforementioned shift register circuit 51a of first stage based on the output signal from the shift register circuit of previous stage, the clock signals VCLK1 and VCLK2, and the enable signal VENB. Thus, the respective gate lines of stages are sequentially driven (scanned). In this case, since the outputs of the shift register circuits are forcedly held at H level while the enable signal VENB is H level, setting the enable signal VENB to H level with the timing as shown in Fig. 6 prevents that output signals of L level of the shift register circuits of a later stage and the previous stage coincide with each other.

In the second embodiment, as mentioned above, the output-side circuit portion 51b is provided with the transistor PT3 for bring the transistor PT1, which is connected to the enable signal line for providing the enable signal VENB that is switched between H level (VVDD) and L level (VVSS), to OFF state when the transistor PT2 connected to the higher voltage supply source VVDD is in ON state. Accordingly, it is possible to suppress that the transistor PT1 and the transistor PT2, which is connected to the higher voltage supply source VVDD, are in ON state at the same time. Accordingly, in the output-side circuit portion 51b, even in the case where the enable signal VENB of L level (VVSS) is provided to the transistor PT1 during a period the transistor PT1 is ON, it is possible to suppress that a flow-through current flows between the enable signal line (VENB) and the higher voltage supply source VVDD through the transistor PT1, to which VVSS is provided, and the transistor PT2, which is connected to the higher voltage supply source VVDD. In addition, each of the first to third circuit portions 511c to 513c is provided with the transistor PT7 for bringing the transistor PT5, which is connected to the lower voltage supply source VVSS, to OFF state when the transistor PT6 connected to the higher voltage supply source VVDD is in ON state. Accordingly, it is possible to suppress that the transistor PT5 connected to the lower voltage supply source VVSS and the transistor PT6 connected to the higher voltage supply source VVDD are in ON state at the same time. As a result, it is possible to suppress that, in each of the first to third circuit portions 511c to 513c, a flow-through current flows between the lower voltage supply source VVSS and the higher voltage supply source VVDD through the transistor PT5 and the transistor PT6. As mentioned above, it is possible to suppress that a flow-through current through the transistors PT1 and PT2 of the output-side circuit portion 51b, and a flow-through current through the transistors PT5 and PT6 of each of the first to third circuit portions 511c to 513c flow. Therefore, it is possible to suppress increase of consumed electric current in the liquid crystal display.

As mentioned above, in the second embodiment, the enable signal VENB of H level (VVDD) is provided from the enable signal line (VENB) to the source of the transistor PT1 during a period where the transistor PT1 is ON in response to the clock signal VCLK2 of L level. Thus, the source voltage of the transistor PT1 can be held at VVDD during a period where the transistor PT1 is ON based on the clock signal VCLK2 of L level, and the enable signal VENB of the voltage of VVSS (L level) can be provided from the enable signal line (VENB) to the source of the transistor PT1 after the transistor PT4 is turned OFF by the clock signal VCLK2 of H level. Accordingly, when the voltage of VVSS is provided to the transistor PT1, since the transistor PT1 can be stably held in ON state due to the function of the capacitor C1 and the MOS capacitor of the transistor PT1 without influence of the clock signal VCLK2, the output (Gate1) of the output-side circuit portion 51b can be reliably brought to VVSS (L level) through the transistor PT1. Furthermore, since the source voltage of the transistor PT1 is brought to VVDD by the enable signal VENB of H level (VVDD) during the period where the transistor PT1 is brought to ON by the clock signal VCLK2, a flow-through current does not flow through the transistor PT1 and the transistor PT2, which is connected to the higher voltage supply source VVDD. As a result, it is also possible to suppress increase of consumed electric current in the liquid crystal display.

In the second embodiment, during a prescribed period where the enable signal VENB of H level is provided from the enable signal line (VENB), the enable signal VENB of H level is provided to the gate line through the transistor PT1. Thus, during the prescribed period where the enable signal VENB of H level is provided from the enable signal line (VENB), the output signal Gate1 provided from the shift register circuit 51a to the gate line can be forcedly held at H level. Accordingly, during the prescribed period where the enable signal VENB of H level is provided from the enable signal line VENB, it is possible to suppress that the output signals, which are provided from the shift register circuit of a prescribed stage and the shift register circuit of the following stage to the respective gate lines corresponding to them, become L level at the same time. As a result, it is not necessary to separately provide a circuit to suppress that the output signals provided from the shift register circuits of the prescribed stage and the following stage to the gate lines become L level at the same time. Therefore, it is possible to simplify the circuit constitution of the shift register circuit.

In addition, the other effects in the second embodiment are similar to the foregoing first embodiment.

### THIRD EMBODIMENT

In a third embodiment, an exemplary H-driver, which is constituted of n-channel transistors, for driving (scanning) drain lines is described.

With reference to Fig. 7, in a liquid crystal display of the third embodiment, a display portion 11 is provided on a circuit board 60. The constitution corresponding to one pixel is shown in the display portion 11 of Fig. 7. Each of pixels 12 arranged in a matrix shape in the display portion 11 is constituted of an n-channel transistor 12a, pixel electrode 12b, a common electrode 12c common to the pixels 12 which is opposed to the pixel electrode 12b, a liquid crystal 12d which is interposed between the pixel electrode 12b and the common electrode 12c, and a subsidiary capacitance 12e. The source of the n-channel transistor 12a is connected to the pixel electrode 12b and the subsidiary capacitance 12e. The drain is connected to the drain line. The gate of the n-channel transistor 12a is connected to a gate line. A horizontal switch (HSW) 13 and an H-driver 14 for driving (scanning) the drain lines of the display portion 11 are provided on the circuit board 60 along one side of the display portion 11. A V-driver 15 for driving (scanning) the gate lines of the display portion 11 is provided on the circuit board 60 along the other side of the display portion 11.

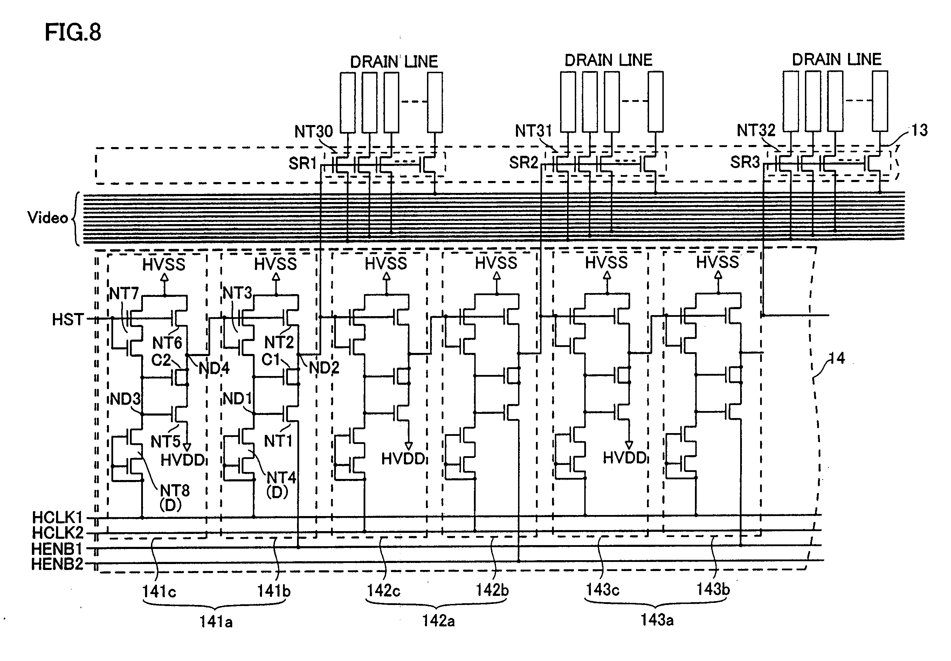

As shown in Fig. 8, a plurality of stages of shift register circuits 141a, 142a, and 143a are provided inside the H-driver 14. In Fig. 8, only three stages of shift register circuits 141a, 142a and 143a are shown for ease of illustration. The shift register circuit 141a of first stage is constituted of an output-side circuit portion 141b and an input-side circuit portion 141c. The output-side circuit portion 141b includes n-channel transistors NT1, NT2 and NT3, a diode-connected n-channel transistor NT4, and a capacitor C1 formed by connecting between the source and the drain of an n-channel transistor. The input-side circuit portion 141c includes n-channel transistors NT5, NT6 and NT7, a diode-connected n-channel transistor NT8, and a capacitor C2 formed by connecting between the source and the drain of an n-channel transistor.

A shift register circuit 142a of second stage is constituted of an output-side circuit portion 142b and an input-side circuit portion 142c. A shift register circuit 143a of third stage is constituted of an output-side circuit portion 143b and an input-side circuit portion 143c. The shift register circuit 142a of second stage and the shift register circuit 143a of third stage have circuit constitution similar to the aforementioned shift register circuit 141a of first stage.

In the third embodiment, all of the n-channel transistors NT1 to NT8 provided in the output-side and input-side circuit portions 141b and 141c, and the n-channel transistors, which constitute the capacitors C1 and C2, are constituted of TFTs (thin-film transistors) composed of n-type MOS transistors (electric field effect transistors). Hereafter, the n-channel transistors NT1 to NT8 are referred to as transistors NT1 to NT8, respectively.

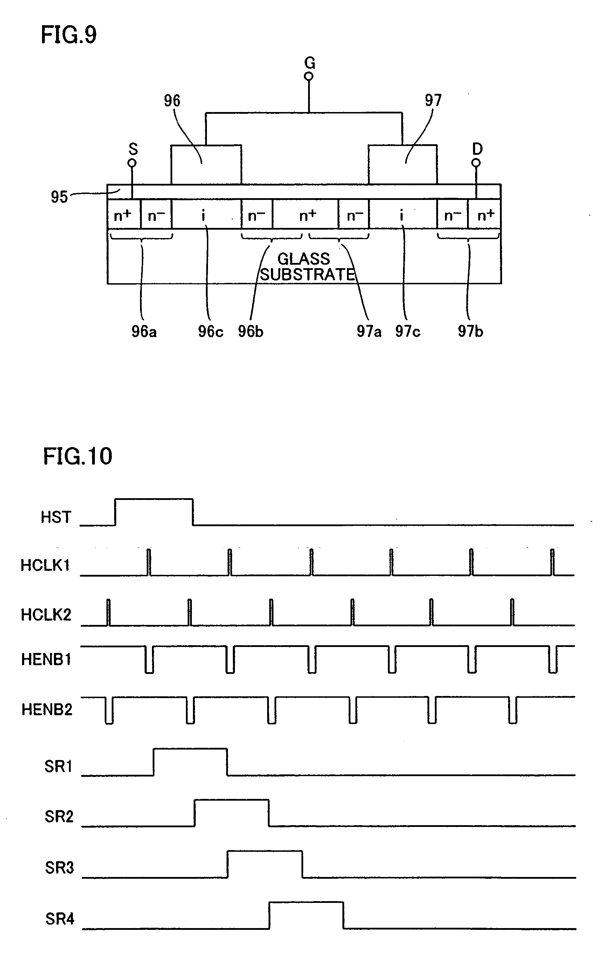

In the third embodiment, as shown in Fig. 9, the transistors NT3, NT4, NT7, and NT8 are formed so that each of them has two gate electrodes 96 and 97 which are electrically connected to each other. Specifically, the gate electrode 96 of one side and the gate electrode 97 of the other side are formed above a channel area 96c of the one side and a channel area 97c of the other side, respectively, so that a gate insulating film 95 is sandwiched between each gate electrode and each channel area. The channel area 96c of the one side is formed so as to be interposed between an n-type source area 96a of LDD (Lightly Doped Drain) structure which has an n-type low concentration impurity region (n-) and an n-type high concentration impurity region (n+) of the one side, and an n-type drain area 96b of LDD structure of the one. The channel area 97c of the other side is formed so as to be interposed between an n-type source area 97a of LDD structure of the other side, and an n-type drain area 97b of LDD structure of the other side. The n-type drain area 96b and the n-type source area 97a have a common n-type high concentration impurity region (n+).

In the third embodiment, as shown in Fig. 8, an enable signal line (HENB1) is connected to the drain of the transistor NT1. Accordingly, an enable signal HENB1 is provided to the drain of the transistor NT1. The respective sources of the transistors NT2, NT3, NT6, and NT7 are connected to the lower voltage supply source HVSS. The drain of the transistor NT5 is connected to the higher voltage supply source HVDD.

The constitution of the parts other than these of the shift register circuit 141a according to the third embodiment is similar to the shift register circuit 41a according to the foregoing first embodiment (see Fig. 2).

The horizontal switch 13 includes a plurality of switching transistors NT30, NT31 and NT32. Each of the switching transistors NT30 to NT32 has a set of twelve n-channel transistors. The respective gates of each set of twelve n-channel transistors of the switching transistors NT30 to NT32 are connected to each of the outputs SR1, SR2, and SR3 of the shift register circuits 141a to 143a of first to third stages. The respective sources of each set of twelve p-channel transistors of the switching transistors NT30 to NT32 are connected to the drain lines of each stage. The respective drains of each set of twelve n-channel transistors of the switching transistors NT30 to NT32 are connected to separated video signal lines Video. More specifically, each of the respective switching transistors NT30 to NT32 of stages is connected to four sets (twelve lines) of video signal lines Video. Each one set of them is constituted of three video signal lines Video corresponding to red (R), green (G) and blue (B), respectively. Accordingly, since the set of twelve n-channel transistors connected to the four RGB sets (twelve lines) of video signal lines Video are driven by the output of the shift register circuit of one stage, the number of the shift register circuits is a quarter the number of the shift register circuits as compared with the constitution where three n-channel transistors connected to one RGB sets (three lines) of video signal lines Video are driven by the output of a shift register circuit of one stage, for example. As a result, power consumption is reduced as compared with the constitution where three n-channel transistors connected to one RGB sets (three lines) of video signal lines Video are driven by the output of a shift register circuit of one stage.

With reference to Fig. 10, in the shift register circuit according to the third embodiment, signals with waveforms whose H level and L level are inverted from those of the clock signals HCLK1 and HCLK2, the start signal HST, and the enable signals HENB1 and HENB2 in the timing chart of the shift register circuit shown in Fig. 4 according to the first embodiment are provided as clock signals HCLK1 and HCLK2, a start signal HST, and enable signals HENB1 and HENB2, respectively. Accordingly, signals with waveforms whose H level and L level are inverted from those of the output signals SR1 to SR4 from the shift register circuits according to the first embodiment are provided from the shift register circuits shown in Fig. 4 of the liquid crystal display according to the third embodiment. The operation other than this operation of the shift register circuit according to the third embodiment is similar to the shift register circuit 41a according to the foregoing first embodiment.

The aforementioned constitution of the third embodiment can provide effects similar to the foregoing first embodiment such as suppression of increase of consumed electric current and deterioration of scanning property in the liquid crystal display including the H-driver 14.

### FOURTH EMBODIMENT

In a fourth embodiment, an exemplary V-driver, which is constituted of n-channel transistors, for driving (scanning) gate lines is described.

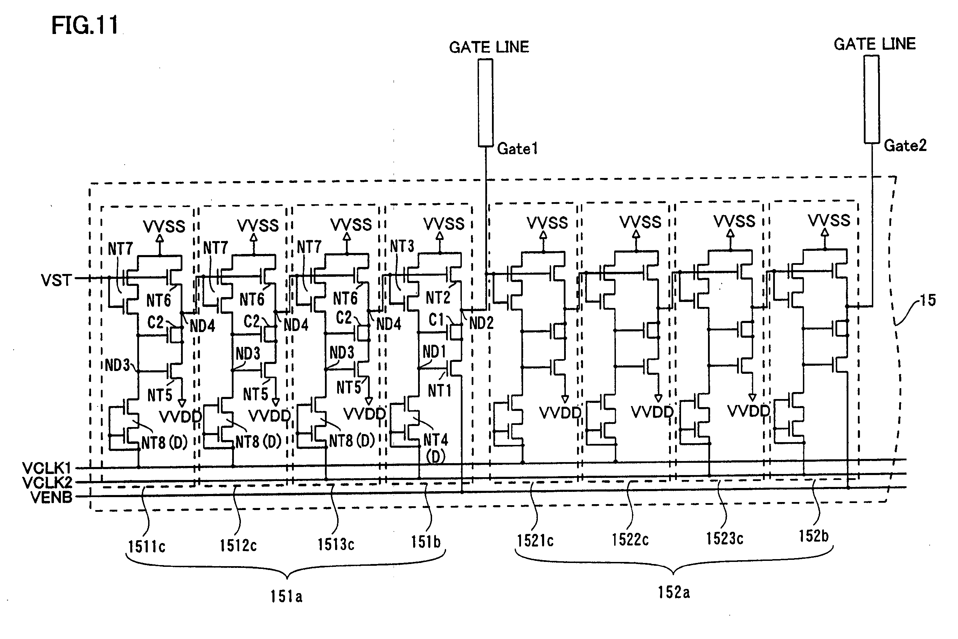

With reference to Fig. 11, a plurality of shift register circuits 151a and 152a are provided inside a V-driver 15. In Fig. 11, only two stages of shift register circuits 151a and 152a are shown for ease of illustration. The shift register circuit 151a of first stage is constituted of an output-side circuit portion 151b, a first circuit portion 1511c, a second circuit portion 1512c, and a third circuit portion 1513c.

The output-side circuit portion 151b includes transistors NT1, NT2 and NT3, a diode-connected transistor NT4, and a capacitor C1 formed by connecting between the source and the drain of an n-channel transistor. The first circuit portion 1511c includes transistors NT5, NT6, NT7 and NT8, and a capacitor C2, which correspond to the transistors NT1, NT2, NT3 and NT4, and the capacitor C1 of the aforementioned output-side circuit portion 151b, respectively.

In the fourth embodiment, all of the transistors NT1 to NT8 provided in the output-side circuit portion 151b and the first circuit portion 1511c, and the transistors, which constitute the capacitors C1 and C2, are constituted of TFTs (thin-film transistors) composed of n-type MOS transistors (electric field effect transistors).

In the fourth embodiment, the transistors NT3, NT4, NT7, and NT8 are formed so that each of them has two gate electrodes which are electrically connected to each other similarly to the third embodiment shown in Fig. 9.

In the fourth embodiment, as shown in Fig. 11, the drain of the transistor NT1 is connected to an enable signal line (VENB) . Accordingly, an enable signal VENB is provided from the enable signal line (VENB) to the drain of the transistor NT1. The respective sources of the transistors NT2, NT3, NT6, and NT7 are connected to the lower voltage supply source VVSS. The drain of the transistor NT5 is connected to the higher voltage supply source VVDD.

The second and third circuit portions 1512c and 1513c of the shift register circuit 151a of first stage have circuit constitution similar to the first circuit portion 1511c. The shift register circuit 152a of second stage is constituted of an output-side circuit portion 152b, a first circuit portion 1521c, a second circuit portion 1522c, and a third circuit portion 1523c. The shift register circuit 152a of second stage has circuit constitution similar to the aforementioned shift register circuit 151a of first stage.

The constitution of the parts other than the aforementioned parts of the shift register circuits 151a and 152a according to the fourth embodiment is similar to the shift register circuit 51a according to the foregoing second embodiment (see Fig. 5).

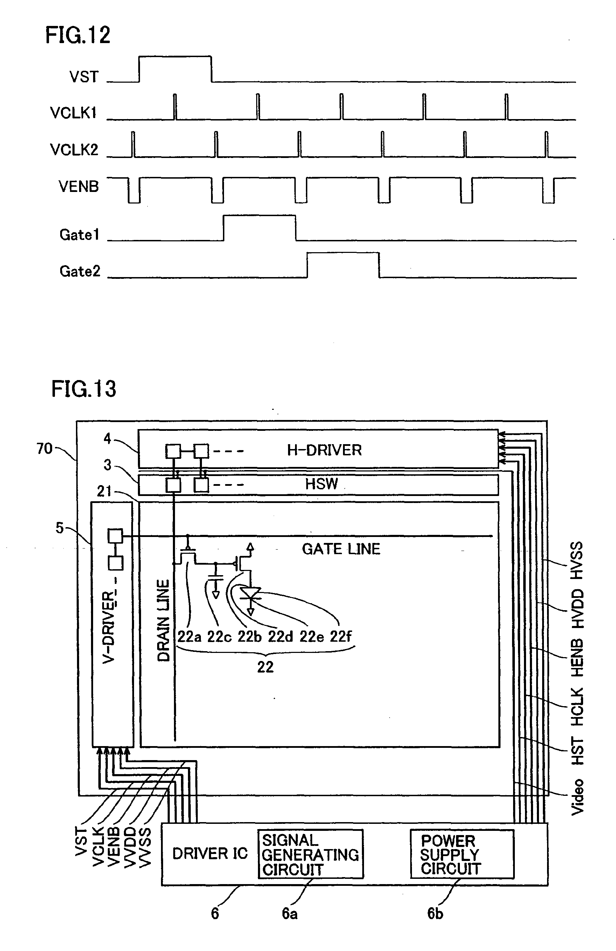

With reference to Fig. 12, in the shift register circuit of the V-driver according to the fourth embodiment, signals with waveforms whose H level and L level are inverted from those of the clock signals VCLK1 and VCLK2, the start signal VST, and the enable signal VENB in the timing chart of the shift register circuit shown in Fig. 6 according to the second embodiment are provided as clock signals VCLK1 and VCLK2, a start signal VST, and an enable signal VENB, respectively. Accordingly, signals with waveforms whose H level and L level are inverted from those of the output signals Gate1 and Gate2 from the shift register circuit according to the second embodiment shown in Fig. 6 are provided from the shift register circuit of the V-driver of the liquid crystal display according to the fourth embodiment. The operation other than this operation of the shift register circuit according to the fourth embodiment is similar to the shift register circuit 51a according to the foregoing second embodiment.

The aforementioned constitution of the fourth embodiment can provide effects similar to the foregoing second embodiment such as suppression of increase of consumed electric current and deterioration of scanning property in the liquid crystal display including the V-driver 15.

### FIFTH EMBODIMENT

With reference to Fig. 13, in a fifth embodiment, an exemplary organic electroluminescence display to which the present invention is applied is described.

In the organic electroluminescence display of the fifth embodiment, as shown in Fig. 13, a display portion 21 is provided on a circuit board 70. The constitution corresponding to one pixel is shown in the display portion 21 of Fig. 13. Each of pixels 22 arranged in a matrix shape in the display portion 21 is constituted of two p-channel transistors 22a and 22b (hereinafter referred to as transistors 22a and 22b), a subsidiary capacitance 22c, an anode 22d, a cathode 22e, and an organic EL element 22f sandwiched between the anode 22d the cathode 22e. The gate of the transistor 22a is connected to a gate line. The source of the transistor 22a is connected to a drain line. The subsidiary capacitance 22c and the gate of the transistor 22b are connected to the drain of the transistor 22a. The drain of the transistor 22b is connected to the anode 22d. The circuit constitution inside an H-driver 4 is similar to the constitution of the H-driver 4 constituted of the shift register circuits using the p-channel transistors shown in Fig. 2. The circuit constitution inside a V-driver 5 is similar to the constitution of the V-driver 5 constituted of the shift register circuits using the p-channel transistors shown in Fig. 5. The constitution of the parts other than these part of the organic electroluminescence display according to the fifth embodiment is similar to the liquid crystal display according to the first embodiment shown in Fig. 1.

The aforementioned constitution of the fifth embodiment can provide effects similar to the foregoing first and second embodiments such as suppression of increase of consumed electric current and deterioration of scanning property in the organic electroluminescence display including the H-drive 4 and the V-driver 5.

### SIXTH EMBODIMENT

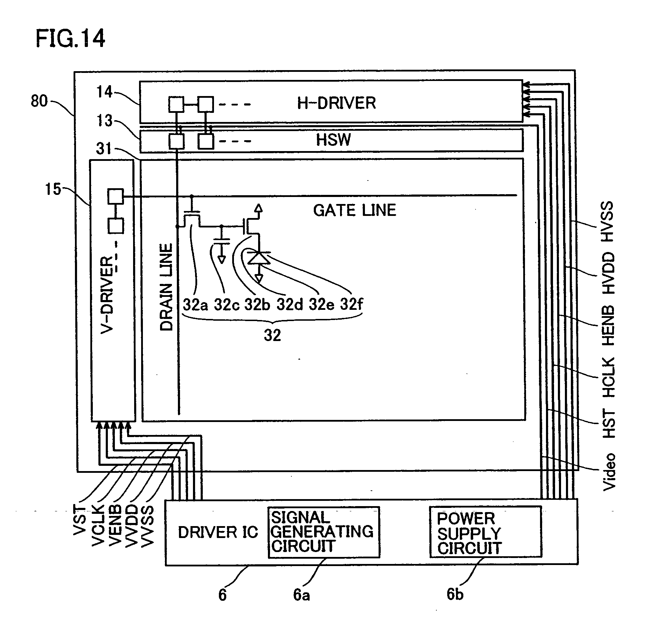

With reference to Fig. 14, in a sixth embodiment, an exemplary organic electroluminescence display to which the present invention is applied is described.

In the organic electroluminescence display of the sixth embodiment, as shown in Fig. 14, a display portion 31 is provided on a circuit board 80. The constitution corresponding to one pixel is shown in the display portion 31 of Fig. 14. Each of pixels 32 arranged in a matrix shape in the display portion 31 is constituted of two n-channel transistors 32a and 32b (hereinafter referred to as transistors 32a and 32b), a subsidiary capacitance 32c, an anode 32d, a cathode 32e, and an organic EL element 32f sandwiched between the anode 32d the cathode 32e. The gate of the transistor 32a is connected to a gate line. The drain of the transistor 32a is connected to a drain line. The subsidiary capacitance 32c and the gate of the transistor 32b are connected to the source of the transistor 32a. The source of the transistor 32b is connected to the anode 32d. The circuit constitution inside a H-driver 14 is similar to the constitution of the H-driver 14 constituted of the shift register circuits using the n-channel transistors shown in Fig. 8. The circuit constitution inside a V-driver 15 is similar to the constitution of the V-driver 15 constituted of the shift register circuits using the n-channel transistors shown in Fig. 11. The constitution of the parts other than these part of the organic electroluminescence display according to the sixth embodiment is similar to the liquid crystal display shown in Fig. 7 according to the third embodiment.

The aforementioned constitution of the sixth embodiment can provide effects similar to the foregoing third and fourth embodiments such as suppression of increase of consumed electric current and deterioration of scanning property in the organic electroluminescence display including the H-drive 14 and the V-driver 15.

It should be appreciated, however, that the embodiments described above are illustrative, and the invention is not specifically limited to description above. The invention is defined not by the foregoing description of the embodiments, but by the appended claims, their equivalents, and various modifications that can be made without departing from the scope of the invention as defined in the appended claims.

For example, the invention is not limited to the aforementioned embodiments, but can be applied to display other than liquid crystal and organic electroluminescence displays.

The invention is not limited to the aforementioned embodiments, but a signal line other than the enable signal line can be used.

The invention is not limited to the aforementioned first to fourth embodiments, but the shift register circuit according to the present invention can be applied to both the H-driver and the V-driver. In this case, it is possible to further reduce a consumed electric current.

The invention is not limited to the aforementioned embodiments, but only the MOS capacitor of the transistor PT1 may serve as a capacitor without providing the first capacitor to the first circuit portion in output-side.

## Claims

1. A display comprising a shift register circuit (41a, 42a, 43a, 51a, 52a, 141a, 142a, 143a, 151a, 152a) including a first circuit portion (41b, 42b, 43b, 51b, 52b, 141b, 142b, 143b, 151b, 152b) in output-side, wherein the first circuit portion in output-side has
a first conductive type first transistor (PT1, NT1) whose source or drain is connected to a signal line (HENB1, HENB2, VENB) provided with a signal switched between a first voltage and a second voltage, the first transistor being ON in response to a clock signal provided from a clock signal line (HCLK1, HCLK2, VCLK1, VCLK2), and said source or drain of the first transistor being provided with a signal of said first voltage from said signal line during at least a period where the first transistor is ON in response to said clock signal,
a first conductive type second transistor (PT2, NT2) connected to the first voltage supply source side, and
a first conductive type third transistor (PT3, NT3) connected between the gate of said first transistor and said first voltage supply source to bring said first transistor to OFF state when said second transistor is in ON state.

2. The display according to claim 1, wherein when a first signal of said second voltage is provided to the gates of said second and third transistors, said second and third transistors turn to ON state, the gate voltage of said first transistor is turned to said first voltage through said third transistor in ON state, and said first transistor turns to OFF state.

3. The display according to claim 1, wherein said first circuit portion in output-side includes a first capacitor (C1) connected between the gate and the source of said first transistor.

4. The display according to claim 3, wherein the gate voltage of said first transistor goes up or drops so as to hold the voltage between the gate and source of said first transistor to which said first capacitor is connected as the source voltage of said first transistor goes up or drops.

5. The display according to claim 1, wherein said shift register circuit includes a shift register circuit (41a, 42a, 43a, 141a, 142a, 143a) for driving a drain line, wherein
said clock signal line includes a first clock signal line (HCLK1) which provides a first clock signal to the gate of the first transistor in said shift register circuit of a prescribed stage, and a second clock signal line (HCLK2) which provides a second clock signal different from said first clock signal in timing to the gate of the first transistor in said shift register circuit of the stage subsequent to said prescribed stage, wherein
said signal line includes a first signal line (HENB1) which provides a signal of said first voltage to at least said first transistor of the shift register circuit of said prescribed stage to which said first clock signal line is connected, and a second signal line (HENB2) which provides a signal of said first voltage to at least said first transistor of the shift register circuit of said stage subsequent to said prescribed stage to which said second clock signal line is connected.

6. The display according to claim 1, wherein said shift register circuit includes a shift register circuit (51a, 52a, 151a, 152a) for driving a gate line, wherein
the signal of said first voltage is provided to said gate line through said first transistor during a prescribed period where the signal of said first voltage is provided from said signal line.

7. The display according to claim 1, wherein said third transistor has two gate electrodes (91, 92) which are electrically connected to each other.

8. The display according to claim 1, wherein at least said first transistor, said second transistor, and said third transistor are p-type electric field effect transistors.

9. The display according to claim 1, wherein said first circuit portion in output-side further includes a diode-connected fourth transistor (PT4, NT4) connected between the gate of said first transistor and the clock signal line providing said clock signal and having two gate electrodes electrically connected to each other.

10. The display according to claim 9, wherein at least said first transistor, said second transistor, said third transistor, and said fourth transistor are p-type electric field effect transistors.

11. The display according to claim 1, wherein said shift register circuit further includes a second circuit portion (41c, 42c, 43c, 141c, 142c, 143c) other than output-side, wherein the second circuit portion other than output-side has
a first conductive type fifth transistor (PT5, NT5) connected to the second voltage supply source side, the fifth transistor being ON in response to said clock signal,
a first conductive type sixth transistor (PT6, NT6) connected to said first voltage supply source side, and
a first conductive type seventh transistor (PT7, NT7) connected between the gate of said fifth transistor and said first voltage supply source to be in OFF state when said third transistor is in ON state, and to bring said sixth transistor to OFF state when said fifth transistor is in ON state.

12. The display according to claim 11, wherein when a second signal of said second voltage is provided to the gates of said sixth and seventh transistors, said sixth and seventh transistors turn to ON state, the gate voltage of said fifth transistor is turned to said first voltage through said seventh transistor in ON state, and said fifth transistor turns to OFF state.

13. The display according to claim 11, wherein a second capacitor (C2) is connected between the gate and the source of said fifth transistor.

14. The display according to claim 13, wherein the gate voltage of said fifth transistor goes up or drops so as to hold the voltage between the gate and source of said fifth transistor to which said second capacitor is connected as the source voltage of said fifth transistor goes up or drops.

15. The display according to claim 11, wherein said seventh transistor has two gate electrodes (91, 92) which are electrically connected to each other.

16. The display according to claim 11, wherein at least said first transistor, said second transistor, said third transistor, said fifth transistor, said sixth transistor, and said seventh transistor are p-type electric field effect transistors.

17. The display according to claim 11, wherein said second circuit portion other than output-side further includes a diode-connected eighth transistor (PT8, NT8) connected between the gate of said fifth transistor and the clock signal line providing said clock signal and having two gate electrodes electrically connected to each other.

18. The display according to claim 17, wherein at least said first transistor, said second transistor, said third transistor, said fifth transistor, said sixth transistor, said seventh transistor, and said eighth transistor are p-type electric field effect transistors.

19. The display according to claim 1, wherein said shift register circuit is applied to at least one of shift register circuit driving a drain line and shift register circuit driving a gate line.

20. The display according to claim 19, wherein said drain line driven by said shift register circuit is connected to a display pixel (2, 12, 22, 32) including at least one of liquid crystal (2d, 12d) and EL element (22f, 32f).
